# EUROPEAN PATENT APPLICATION

(11) **EP 4 258 842 A1**
(43) Date of publication of application: **11.10.2023**
(21) Application number: 23160241.8
(22) Date of filing: 06.03.2023
(51) Int. Cl.: H10B 43/27, H01L 21/768, H10B 43/50, H10B 41/27, H10B 41/50

(54) **SEMICONDUCTOR DEVICE AND ELECTRONIC SYSTEM INCLUDING THE SAME**

(30) Priority: 22.03.2022 KR 20220035445
(71) Applicant: Samsung Electronics Co., Ltd., Suwon-si, Gyeonggi-do 16677 (KR)
(72) Inventor: KWON, Donghoon, 16677 Suwon-si (KR); YOON, Boun, 16677 Suwon-si (KR); JANG, Kihoon, 16677 Suwon-si (KR)
(74) Representative: Marks & Clerk LLP

(57) **Abstract**

A semiconductor device includes a first semiconductor structure including a first substrate and a second semiconductor structure on the first semiconductor structure. The second semiconductor structure includes gate electrodes stacked on the second substrate, interlayer insulating layers alternately stacked with the gate electrodes, through-insulating regions passing through the gate electrodes in a second region, a capping insulating layer covering the gate electrodes and the interlayer insulating layers, an upper insulating layer on the capping insulating layer, channel structures passing through the capping insulating layer and the gate electrodes in a first region, upper contact plugs passing through the upper insulating layer, bit lines on the upper insulating layer, first contact plugs passing through the capping insulating layer, and conductive patterns including second contact plugs passing through each of the through-insulating regions in the second region. The conductive patterns include connection portions integral with the second contact plugs.

## Description

### FIELD

The present inventive concepts relate to a semiconductor device and/or an electronic system including the same.

### BACKGROUND

In an electronic system desiring or requiring data storage, a semiconductor device for storing high-capacity data may be desired or required. Accordingly, methods for increasing data storage capacity of semiconductor devices are being researched. For example, as a method for increasing data storage capacity of a semiconductor device, a semiconductor device including memory cells arranged three-dimensionally, instead of memory cells arranged two-dimensionally, has been proposed.

### SUMMARY

Some example embodiments of the present inventive concepts provide a semiconductor device having improved operating speed and reliability.

Some example of the present inventive concepts provide an electronic system including a semiconductor device having improved operating speed and reliability.

According to some example embodiments of the present inventive concepts, a semiconductor device includes a first semiconductor structure including a first substrate, circuit elements on the first substrate, and lower interconnection lines electrically connected to the circuit elements, and a second semiconductor structure on the first semiconductor structure. The second semiconductor structure includes a second substrate including a first region and a second region, gate electrodes stacked on the second substrate, the gate electrodes spaced apart from each other in a first direction, interlayer insulating layers alternately stacked with the gate electrodes, through-insulating regions passing through the gate electrodes in the second region, the through-insulating regions extending in a second direction, a capping insulating layer covering the gate electrodes and the interlayer insulating layers, an upper insulating layer on the capping insulating layer, channel structures passing through the capping insulating layer and the gate electrodes in the first region, each of the channel structures extending in the first direction and including a channel layer, upper contact plugs passing through the upper insulating layer, each of the upper contact plugs connected to at least one of the channel structures, bit lines on the upper insulating layer, each of the bit lines connected to at least one of the upper contact plugs, first contact plugs passing through the capping insulating layer in the second region, each of the first contact plugs extending in the first direction and electrically connected to at least one of the gate electrodes, and conductive patterns including second contact plugs passing through each of the through-insulating regions in the second region, the second contact plugs extending in the first direction and electrically connected to the lower interconnection lines. The conductive patterns include connection portions integral with the second contact plugs, the connection portions extending to surround an upper surface and at least a portion of a side surface of the first contact plugs.

According to some example embodiments of the present inventive concepts, a semiconductor device includes a first semiconductor structure including a lower interconnection structure, and a second semiconductor structure on the first semiconductor structure. The second semiconductor structure includes gate electrodes stacked on the first semiconductor structure, the gate electrodes spaced apart from each other in a first direction, interlayer insulating layers alternately stacked with the gate electrodes, a capping insulating layer covering the gate electrodes and the interlayer insulating layers, a first contact plug passing through the capping insulating layer, the first contact plug extending in the first direction and electrically connected to the gate electrodes, a second contact plug extending in the first direction, the second contact plug spaced apart from the gate electrodes and electrically connected to the lower interconnection structure, and a connection portion electrically connecting the first contact plug and the second contact plug, and the connection portion on the capping insulating layer, wherein the connection portion and the second contact plug are integral.

According to some example embodiments of the present inventive concepts, an electronic system includes a semiconductor storage device including a first semiconductor structure including a lower interconnection structure, the semiconductor storage device including a second semiconductor structure on the first semiconductor structure, and the semiconductor storage device including an input/output pad electrically connected to the lower interconnection structure. The system includes a controller electrically connected to the semiconductor storage device through the input/output pad, the controller configured to control the semiconductor storage device. The second semiconductor structure includes gate electrodes stacked on the first semiconductor structure, the gate electrodes spaced apart from each other in a first direction, interlayer insulating layers alternately stacked with the gate electrodes, a capping insulating layer covering the gate electrodes and the interlayer insulating layers, a first contact plug passing through the capping insulating layer, the first contact plug extending in the first direction and electrically connected to the gate electrodes, a second contact plug extending in the first direction, the second contact plug spaced apart from the gate electrodes and electrically connected to the lower interconnection structure, and a connection portion electrically connecting the first contact plug and the second contact plug, and the connection portion on the capping insulating layer, wherein the connection portion and the second contact plug are integral.

At least some of the above and other features of the invention are set out in the claims.

### BRIEF DESCRIPTION OF DRAWINGS

The above and other features and advantages of the present inventive concepts will be more clearly understood from the following detailed description, taken in conjunction with the accompanying drawings, in which:
FIG. 1 is a schematic layout diagram of a semiconductor device according to some example embodiments.
FIGS. 2A, 2B and 2C are schematic cross-sectional views of a semiconductor device according to some example embodiments.
FIGS. 3, 4 and 5 are partially enlarged views of a semiconductor device according to some example embodiments.
FIG. 6A is a schematic cross-sectional view of a semiconductor device according to some example embodiments.
FIG. 6B is a partially enlarged view of a semiconductor device according to some example embodiments.
FIG. 7 is a partially enlarged view of a semiconductor device according to some example embodiments.
FIG. 8 is a partially enlarged view of a semiconductor device according to some example embodiments.
FIGS. 9A and 9B are layout diagrams schematically illustrating a semiconductor device according to some example embodiments.
FIG. 10 is a layout diagram schematically illustrating a semiconductor device according to some example embodiments.
FIGS. 11A, 11B, 11C, 11D, 11E, 11F, 11G, 11H and 11I are schematic cross-sectional views illustrating a method of manufacturing a semiconductor device according to some example embodiments.
FIG. 12 is a view schematically illustrating an electronic system including a semiconductor device according to some example embodiments.
FIG. 13 is a perspective view schematically illustrating an electronic system including a semiconductor device according to some example embodiments.
FIG. 14 is a cross-sectional view schematically illustrating a semiconductor package according to some example embodiments.

### DETAILED DESCRIPTION

Hereinafter, some example embodiments of the present inventive concepts will be described with reference to the accompanying drawings.

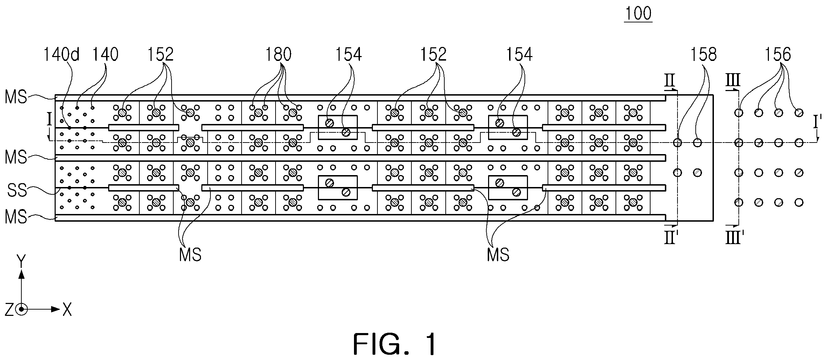

FIG. 1 is a schematic layout diagram of a semiconductor device according to some example embodiments.

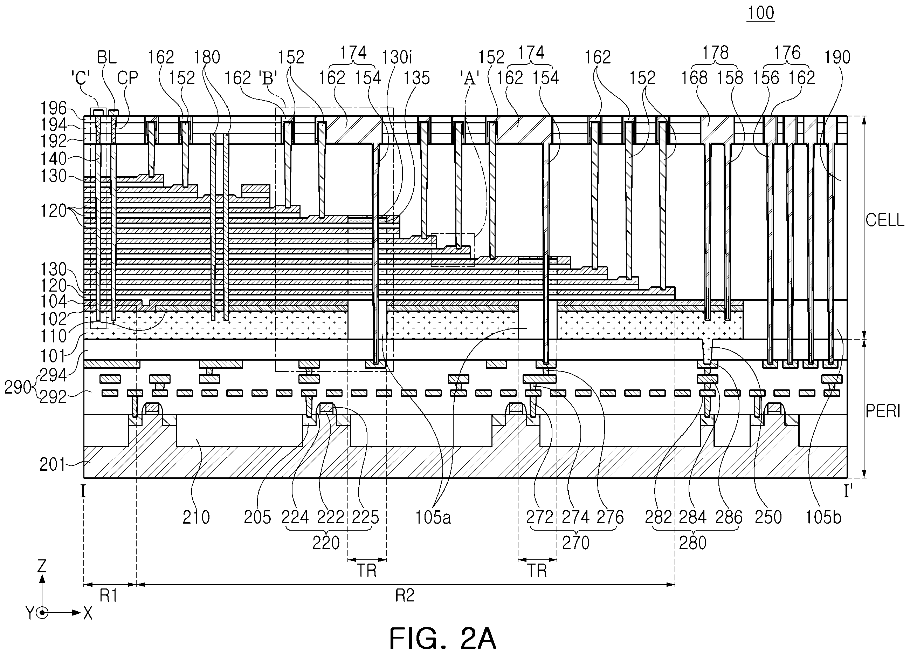

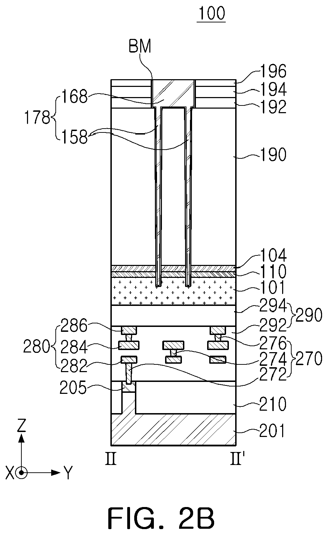

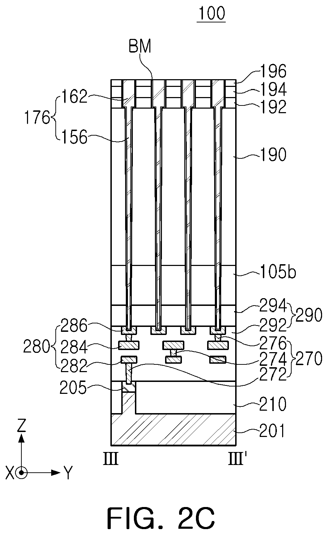

FIGS. 2A to 2C are schematic cross-sectional views of a semiconductor device according to some example embodiments. FIGS. 2A to 2C illustrate cross-sectional views of the semiconductor device of FIG. 1, taken along lines I-I', II-II', and III-III', respectively.

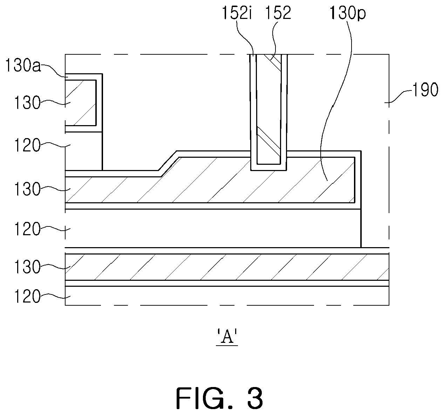

FIGS. 3 to 5 are partially enlarged views of a semiconductor device according to some example embodiments. FIGS. 3 to 5 illustrate enlarged views of portions 'A,' `B,' and 'C' of FIG. 2A, respectively.

Referring to FIGS. 1 to 5, a semiconductor device 100 may include a peripheral circuit region PERI, which is a first semiconductor structure, including a first substrate 201, and a memory cell region CELL, which is a second semiconductor structure, including a second substrate 101. The memory cell region CELL may be disposed on the peripheral circuit region PERI. Conversely, in some example embodiments, the cell region CELL may be disposed below the peripheral circuit region PERI.

The peripheral circuit region PERI may include a first substrate 201, impurity regions 205 and device isolation layers 210, in the first substrate 201, and circuit elements 220, a ground via 250, lower contact plugs 270, lower interconnection lines 280, and a peripheral region insulating layer 290, arranged on the first substrate 201.

The first substrate 201 may have an upper surface extending in an X-direction and a Y-direction. An active region may be defined in the first substrate 201 by the device isolation layer 210. The impurity regions 205 including impurities may be disposed in a portion of the active region. The first substrate 201 may include a semiconductor material, for example, a group IV semiconductor, a group III-V compound semiconductor, or a group II-VI compound semiconductor, but example embodiments are not limited thereto. The first substrate 201 may be provided as a bulk wafer, as an epitaxial layer, etc.

The circuit elements 220 may include planar transistors. Each of the circuit elements 220 may include a circuit gate dielectric layer 222, a spacer layer 224, and a circuit gate electrode 225. The impurity regions 205 may be disposed as source/ drain regions in the first substrate 201 on both sides of the circuit gate electrode 225.

The peripheral region insulating layer 290 may be disposed on the circuit element 220 on the first substrate 201. The peripheral region insulating layer 290 may include first and second peripheral region insulating layers 292 and 294, and the first and second peripheral region insulating layers 292 and 294 may also include a plurality of insulating layers, respectively. The peripheral region insulating layer 290 may be formed of an insulating material.

A lower protective layer (not illustrated) may be disposed between the first peripheral region insulating layer 292 and the second peripheral region insulating layer 294 to cover upper surfaces of third lower interconnection lines 286, which are uppermost lower interconnection lines. In some example embodiments, the lower protective layer may be further disposed on upper surfaces of first and second lower interconnection lines 282 and 284. The lower protective layer may be a layer for inhibiting or preventing contamination of the lower interconnection lines 280 by a metal material disposed thereunder. The lower protective layer may be formed of an insulating material, different from that of the peripheral region insulating layer 290, and may include, for example, silicon nitride.

The lower contact plugs 270 and the lower interconnection lines 280 may form a lower interconnection structure electrically connected to the circuit elements 220 and the impurity regions 205. The lower contact plugs 270 may have a cylindrical shape, and the lower interconnection lines 280 may have a linear shape, but example embodiments are not limited thereto. The lower contact plugs 270 may include first to third lower contact plugs 272, 274, and 276. The first lower contact plugs 272 may be disposed on the circuit elements 220 and the impurity regions 205, the second lower contact plugs 274 may be disposed on the first lower interconnection lines 282, and the third lower contact plugs 276 may be disposed on the second lower interconnection lines 284. The lower interconnection lines 280 may include the first to third lower interconnection lines 282, 284, and 286. The first lower interconnection lines 282 may be disposed on the first lower contact plugs 272, the second lower interconnection lines 284 may be disposed on the second lower contact plugs 274, and the third lower interconnection lines 286 may be disposed on the third lower contact plugs 276. The lower contact plugs 270 and the lower interconnection lines 280 may include a conductive material, may include, for example, tungsten (W), copper (Cu), aluminum (Al), or the like, respectively, and each of them may further include a diffusion barrier. In some example embodiments, the number of layers and an arrangement of the lower contact plugs 270 and the lower interconnection lines 280 may be variously changed.

The ground via 250 may be disposed in the peripheral circuit region PERI to connect the first substrate 201 and the second substrate 101. The ground via 250 may serve to ground the second substrate 101 and a second horizontal conductive layer 104, during a manufacturing process of the semiconductor device 100, to inhibit prevent occurrence of arcing. Although only a portion thereof is illustrated in FIG. 2A, the ground via 250 may be disposed in the semiconductor device 100 as a plurality of ground vias 250 spaced apart from each other at regular intervals in the Y-direction. The ground via 250 may be disposed below the second substrate 101, but the present inventive concepts are not limited thereto. As illustrated in FIG. 2A, the ground via 250 may be connected to a portion of the lower interconnection structure, to form a ground structure including a conductive plug and conductive lines. According to some embodiments, the ground via 250 may directly connect the first substrate 201 and the second substrate 101. The ground via 250 may include a semiconductor material, for example, at least one of silicon (Si) or germanium (Ge), and may further include impurities. According to some example embodiments, the ground via 250 may not be formed integrally with the second substrate 101, but may be formed of a material, different from that of the second substrate 101.

The memory cell region CELL may include a second substrate 101 having a first region R1 and a second region R2, a gate electrodes 130 stacked on the second substrate 101, first and second horizontal conductive layers 102 and 104 disposed below the gate electrodes 130 in the first region R1, a horizontal insulating layer 110 disposed below the gate electrodes 130 in the second region R2, isolation regions MS extending to pass through a stack structure of the gate electrodes 130, and upper isolation regions SS passing through a portion of the stack structure. The memory cell region CELL may further include substrate insulating layers 105a and 105b, the interlayer insulating layers 120 alternately stacked with the gate electrodes 130 on the second substrate 101, a cell region insulating layer 190 covering the gate electrodes 130, and upper insulating layers 192, 194, and 196 disposed on the cell region insulating layer 190.

The memory cell region CELL may further include channel structures 140 disposed to pass through the stack structure, upper contact plugs CP connected to the channel structures 140, bit lines BL respectively connected to the upper contact plugs CP, first contact plugs 152 connected to the gate electrodes 130, the second contact plugs 154 and 156 connected to the lower interconnection structure, and third contact plugs 158 connected to the second substrate 101.

The first region R1 of the second substrate 101 may be a region in which the gate electrodes 130 are vertically stacked and the channel structures 140 are disposed, and may be a region in which memory cells are disposed. The second region R2 may be a region in which the gate electrodes 130 extend to have different lengths, and may correspond to a region for electrically connecting the memory cells to the peripheral circuit region PERI. The second region R2 may be disposed on at least one end of the first region R1 in at least one direction, for example, the X-direction. The second substrate 101 may have a plate shape, and may function as at least a portion of a common source line of the semiconductor device 100.

The second substrate 101 may have an upper surface extending in the X-direction and the Y-direction. The second substrate 101 may include a semiconductor material, for example, a group IV semiconductor, a group III-V compound semiconductor, or a group II-VI compound semiconductor. For example, the group IV semiconductor may include silicon, germanium, or silicon-germanium. The second substrate 101 may further include impurities. The second substrate 101 may be provided as an epitaxial layer or a polycrystalline semiconductor layer such as a polycrystalline silicon layer, but example embodiments are not limited thereto.

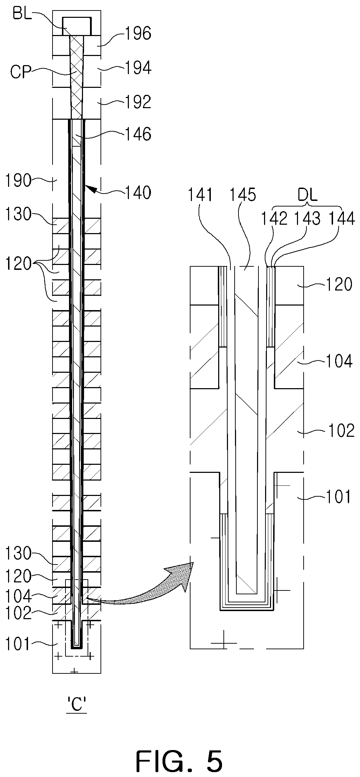

The first and second horizontal conductive layers 102 and 104 may be stacked sequentially and disposed on the upper surface of the second substrate 101 in the first region R1. The first horizontal conductive layer 102 may not extend to the second region R2 of the second substrate 101, and the second horizontal conductive layer 104 may extend to the second region R2. The first horizontal conductive layer 102 may function as a portion of a common source line of the semiconductor device 100, and may function, for example, as a common source line together with the second substrate 101. As illustrated in the enlarged view of FIG. 5, the first horizontal conductive layer 102 may be directly connected to a channel layer 141 around the channel layer 141. The second horizontal conductive layer 104 may be in contact with the second substrate 101 in some regions in which the first horizontal conductive layer 102 and the horizontal insulating layer 110 are not disposed. The second horizontal conductive layer 104 may be bent to extend onto the second substrate 101 while covering an end portion of the first horizontal conductive layer 102 or the horizontal insulating layer 110 in the partial regions.

The first and second horizontal conductive layers 102 and 104 may include a semiconductor material, and may include, for example, polycrystalline silicon. In some example embodiments, at least, the first horizontal conductive layer 102 may be a layer doped with an impurity of the same conductivity type as that of the second substrate 101, and the second horizontal conductive layer 104 may be a doped layer or may be a layer including impurities diffused from the first horizontal conductive layer 102. A material of the second horizontal conductive layer 104 is not limited to the semiconductor material, and may be replaced with an insulating layer.

The horizontal insulating layer 110 may be disposed on the second substrate 101 in parallel to the first horizontal conductive layer 102 in at least a portion of the second region R2. The horizontal insulating layer 110 may include a plurality of horizontal insulating layers (not illustrated) alternately stacked on the second substrate 101 in the second region R2. The horizontal insulating layer 110 may be a layer remaining after a portion of the first horizontal conductive layer 102 is replaced, in the manufacturing process of the semiconductor device 100.

The horizontal insulating layer 110 may include silicon oxide, silicon nitride, silicon carbide, or silicon oxynitride, but example embodiments are not limited thereto. A plurality of horizontal insulating layers may include the same or different materials.

The first substrate insulating layers 105a may be disposed on the second peripheral region insulating layer 294 in a region from which a portion of the second substrate 101, a portion of the horizontal insulating layer 110, and a portion of the second horizontal conductive layer 104 are removed. The second substrate insulating layer 105b may be disposed on an outer side surface of the second substrate 101, an outer side surface of the horizontal insulating layer 110, and an outer side surface of the second horizontal conductive layer 104, on the second peripheral region insulating layer 294. Lower surfaces of the first and second substrate insulating layers 105a and 105b may be coplanar or substantially coplanar with a lower surface of the second substrate 101 or may be located on a level, lower than the lower surface of the second substrate 101. Upper surfaces of the first and second substrate insulating layers 105a and 105b may be coplanar or substantially coplanar with an upper surface of the second horizontal conductive layer 104, or may be located on a level, lower than the upper surface of the second horizontal conductive layer 104. In some example embodiments, the first and second substrate insulating layers 105a and 105b may include a plurality of layers stacked on the second peripheral region insulating layer 294. The first and second substrate insulating layers 105a and 105b may be formed of an insulating material, and may include, for example, silicon oxide, silicon oxynitride, or silicon nitride, but example embodiments are not limited thereto.

The gate electrodes 130 may be stacked on the second substrate 101 to be vertically spaced apart from each other, to form a stack structure. The gate electrodes 130 may include lower gate electrodes forming a gate of a ground select transistor, memory gate electrodes forming a plurality of memory cells, and upper gate electrodes forming gates of string select transistors. The number of memory gate electrodes constituting the memory cells may be determined according to the capacity of the semiconductor device 100. According to embodiments, the number of upper and lower gate electrodes may be 1 to 4 or more, respectively, and may have the same or different structure as the memory gate electrodes. In some example embodiments, the gate electrodes 130 may further include a gate electrode 130 disposed above the upper gate electrodes and/or below the lower gate electrodes, and constituting an erase transistor used for an erase operation using a gate induced drain leakage (GIDL) phenomenon. In addition, some of the gate electrodes 130, for example, memory gate electrodes adjacent to the upper or lower gate electrodes may be dummy gate electrodes.

The gate electrode 130 may be stacked to be vertically spaced apart from each other in the first region R1, and may extend from the first region R1 to the second region R2 at different lengths, to form a step structure in the second region R2. The gate electrode 130 may have regions in which the lower gate electrode 130 extends longer than the upper gate electrode 130, to expose an upper portion of the gate electrode 130 from the interlayer insulating layers 120.

The gate electrodes 130 may include a metal material, for example, tungsten (W). According to some example embodiments, the gate electrodes 130 may include polycrystalline silicon or a metal silicide material. As illustrated in FIG. 3, the gate electrodes 130 may further include a diffusion barrier layer. For example, the diffusion barrier layer may include tungsten nitride (WN), tantalum nitride (TaN), titanium nitride (TiN), or a combination thereof, but example embodiments are not limited thereto.

As illustrated in FIG. 3, the semiconductor device 100 may further include gate pads 130p and a gate dielectric layer 130a. The gate pads 130p may be arranged in a step shape in the second region R2. The gate pads 130p may have a thickness, thicker than a thickness of each of the gate electrodes 130 located in the memory cell region CELL. The gate dielectric layer 130a may cover an upper surface and a lower surface of each of the gate electrodes 130. The gate dielectric layer 130a may be disposed between each of the gate electrodes 130 and each of the channel structures 140, and may be disposed between each of the gate electrodes 130 and each of the support vertical structures 180.

The interlayer insulating layers 120 may be disposed between the gate electrodes 130. Like the gate electrodes 130, the interlayer insulating layers 120 may be spaced apart from each other in a direction, perpendicular or substantially perpendicular to the upper surface of the second substrate 101 and may be disposed to extend in the X-direction. The interlayer insulating layers 120 may include an insulating material such as silicon oxide or silicon nitride.

A through-insulating region TR may pass through the gate electrodes 130 in the second region R2, and may extend in one direction, for example, in the X-direction. The through-insulating region TR may be provided as a single through-insulating region or a plurality of through-insulating regions.

The through-insulating region TR may include sacrificial insulating layers 135 located on the same level as gate electrodes 130 adjacent to the through-insulating region TR, among the gate electrodes 130. In some example embodiments, the through-insulating region TR may further include a reinforcing horizontal layer 130i contacting an uppermost sacrificial insulating layer 135 on a sacrificial insulating layer located at the top, among the sacrificial insulating layers 135.

In some example embodiments, the sacrificial insulating layers 135 may be formed of an insulating material, different from that of the interlayer insulating layers 120. For example, the sacrificial insulating layers 135 may be formed of a first silicon nitride, and the interlayer insulating layers 120 may be formed of silicon oxide. The reinforcing horizontal layer 130i may be formed of a second silicon nitride having an etching rate, different from that of the first silicon nitride of the sacrificial insulating layers 135. The second silicon nitride may be a material having an etching rate, faster than that of the first silicon nitride.

The channel structures 140 may be disposed to be spaced apart from each other while forming rows and columns in the first region R1. The channel structures 140 may be disposed to form a grid pattern in a XY plane, or may be disposed in a zigzag shape in one direction. The channel structures 140 may have a columnar shape, and may have inclined side surfaces that become narrower toward the second substrate 101, according to an aspect ratio. In some example embodiments, channel structures 140d passing through the upper isolation regions SS may be dummy channels that do not substantially form a memory cell string. The dummy channel structures 140d may have the same or substantially the same cross-sectional structure as the channel structures 140, and may be formed of the same or substantially the same material as the channel structures 140.

As illustrated in the enlarged view of FIG. 5, a channel layer 141 may be disposed in the channel structures 140. In the channel structures 140, the channel layer 141 may be formed in an annular shape surrounding a channel buried insulating layer 145 therein. According to some example embodiments, the channel layer 141 may have a columnar shape such as a cylinder or a prism, without the channel filling insulating layer 145. The channel layer 141 may be connected to the first horizontal conductive layer 102 at the bottom. The channel layer 141 may include a semiconductor material such as polycrystalline silicon or monocrystalline silicon.

A gate dielectric layer DL may be disposed between the gate electrodes 130 and the channel layer 141. The gate dielectric layer DL may include a tunneling layer 142, a charge storage layer 143, and a blocking layer 144, sequentially arranged from the channel layer 141. The tunneling layer 142 may tunnel charges to the charge storage layer 143, and for example, may include silicon oxide (SiO₂), silicon nitride (Si₃N₄), silicon oxynitride (SiON), or a combination thereof. The charge storage layer 143 may be a charge trap layer or a floating gate conductive layer. The blocking layer 144 may include silicon oxide (SiO₂), silicon nitride (Si₃N₄), silicon oxynitride (SiON), a high-k dielectric material, or a combination thereof, but example embodiments are not limited thereto. In some example embodiments, at least a portion of the gate dielectric layer DL may extend in a horizontal direction along the gate electrodes 130. Channel pads 146 may be disposed on an upper end of each of the channel structures 140. The channel pads 146 may include, for example, doped polycrystalline silicon.

The isolation regions MS may be disposed to pass through the gate electrodes 130 in the first region R1 and the second region R2 and extend in the X-direction. As illustrated in FIG. 1, the isolation regions MS may be disposed parallel or substantially parallel to each other. Some of the isolation regions MS may extend together along the first region R1 and the second region R2, and the other portion thereof may extend only to a portion of the second region R2 or may be intermittently disposed in the first region R1 and the second region R2. In some example embodiments, an arrangement order, an arrangement interval, or the like of the isolation regions MS may be variously changed. The isolation regions MS may entirely pass through the gate electrodes 130 stacked on the second substrate 101, to be connected to the second substrate 101. A separation insulating layer may be disposed in the isolation regions MS.

The upper isolation regions SS may extend between the isolation regions MS in the X-direction. The upper isolation regions SS may be disposed in a portion of the second region R2 and the first region R1, to pass through a portion of the gate electrodes 130 including an uppermost gate electrode 130 among the gate electrodes 130. The upper isolation regions SS may separate, for example, a total of three gate electrodes 130 from each other in the Y-direction. The number of gate electrodes 130 separated by the upper isolation regions SS may be variously changed according to example embodiments.

The cell region insulating layer 190 may be disposed to cover the second substrate 101, the gate electrodes 130 on the second substrate 101, and the peripheral region insulating layer 290. The cell region insulating layer 190 may be referred to as a capping insulating layer. The cell region insulating layer 190 may be formed of an insulating material. The upper insulating layers 192, 194, and 196 may be disposed on the cell region insulating layer 190. The upper insulating layers 192, 194, and 196 may be formed of an insulating material, and may include a plurality of insulating layers, for example, first to third upper insulating layers 192, 194, and 196.

The semiconductor device 100 may include an upper interconnection structure including the upper contact plugs CP, the bit lines BL, the first to third contact plugs 152, 154, 156, and 158, and the first and second connection portions 162 and 168. The upper interconnection structure will be described below with reference to FIGS. 3 to 5.

The upper contact plugs CP may be interconnection structures electrically connected to the channel structures 140. The upper contact plugs CP may pass through at least a portion of the first to third upper insulating layers 192, 194, and 196, and may be connected to the upper surfaces of the channel structures 140. The upper contact plugs CP may include a conductive material, may include, for example, tungsten (W), copper (Cu), aluminum (Al), or the like, and may further include a diffusion barrier layer.

The bit line BL may be disposed on the upper surface of the upper insulating layer 196. The bit line BL may be electrically connected to the channel structure 140 through the upper contact plug CP.

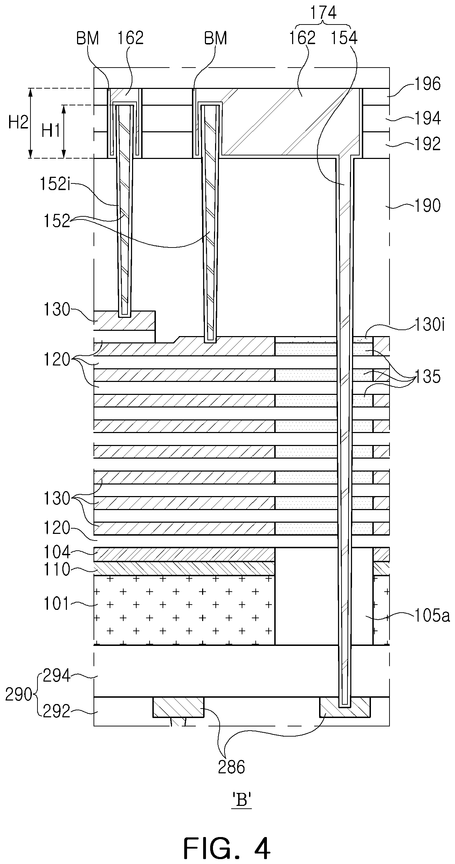

The first contact plugs 152 may be connected to the gate electrodes 130 in the second region R2. The first contact plugs 152 may pass through a portion of the cell region insulating layer 190 and portions of the upper insulating layers 192 and 194, and may be disposed to be respectively connected to upwardly exposed gate electrodes 130. As illustrated in FIG. 4, the first contact plugs 152 may pass through the gate dielectric layer 130a of the gate pads 130p and a portion of the gate pads 130p, respectively, to be respectively connected to the gate pads 130p.

As illustrated in FIGS. 3 and 4, a liner layer 152i may surround side and bottom surfaces of the first contact plug 152. The liner layer 152i may include at least one of a metal material such as titanium (Ti) or the like, or a metal nitride such as titanium nitride (TiN) or the like. The first contact plug 152 may include a metal material such as tungsten (W) or the like.

The second contact plugs 154 and 156 may pass through a portion of the cell region insulating layer 190, a portion of the substrate insulating layers 105a and 105b, and a portion of the peripheral region insulating layer 290, and may extend in a direction, perpendicular or substantially perpendicular to the upper surface of the second substrate 101. The second contact plugs 154 and 156 may be connected to the lower interconnection structure.

The second contact plugs 154 may pass through at least a portion of the cell region insulating layer 190, at least a portion of the through-insulating region TR, at least a portion of the substrate insulating layers 105a, and at least a portion of the peripheral region insulating layer 290, and may extend in a direction, perpendicular or substantially perpendicular to the upper surface of the second substrate 101. The second contact plugs 154 may be spaced apart from adjacent gate electrodes 130 by the through-insulating region TR. The second contact plugs 154 may be disposed between the first contact plugs 152 in the X-direction.

The second contact plugs 156 may be disposed in an outer region from the second substrate 101, and may extend into the peripheral circuit region PERI. The second contact plugs 156 may pass through at least a portion of the cell region insulating layer 190, at least a portion of the substrate insulating layers 105b, and at least a portion of the peripheral region insulating layer 290, and may extend in a direction, perpendicular or substantially perpendicular to the upper surface of the second substrate 101. For example, the second contact plugs 156 may be disposed on one side of the first contact plugs 152 in a direction, opposite to a direction in which the first contact plugs 152 face the first region R1.

The first connection portions 162 may connect one first contact plug 152 and at least one of the second contact plug 154 or the second contact plug 156, respectively. Hereinafter, an example embodiment in which the first connection portion 162 connects the first contact plug 152 and the second contact plug 154 will be mainly described with reference to FIG. 4.

The first connection portion 162 may be integrally formed with the second contact plugs 154 to form a first conductive pattern 174. The first connection portion 162 and the second contact plug 154 may be formed of the same material, and an interface may not exist between the first connection portion 162 and the second contact plug 154.

The first connection portion 162 may pass through at least a portion of the upper insulating layers 192, 194, and 196 to extend in a direction, intersecting a longitudinal direction of the second contact plug 154, for example, in the X-direction. Although FIG. 4 illustrates an embodiment in which the first connection portion 162 passes through the first to third upper insulating layers 192, 194, and 196 and is disposed on the cell region insulating layer 190, but the present inventive concepts are not limited thereto. In other example embodiments, the first connection portion 162 may pass through a portion of the cell region insulating layer 190. The first connection portion 162 may be in contact with, or may not be in contact with the support vertical structures 180.

The first connection portion 162 may cover a portion of upper and side surfaces of the first contact plug 152. An interface may exist between the first connection portion 162 and the first contact plug 152. In some example embodiments, a barrier metal layer BM may exist between the first connection portion 162 and the first contact plug 152. The barrier metal layer BM may cover a surface of the first conductive pattern 174. The barrier metal layer BM may cover an entire surface of the first conductive pattern 174 except for an upper surface thereof. The first connection portion 162 may be separate and distinct from the first contact plug 152.

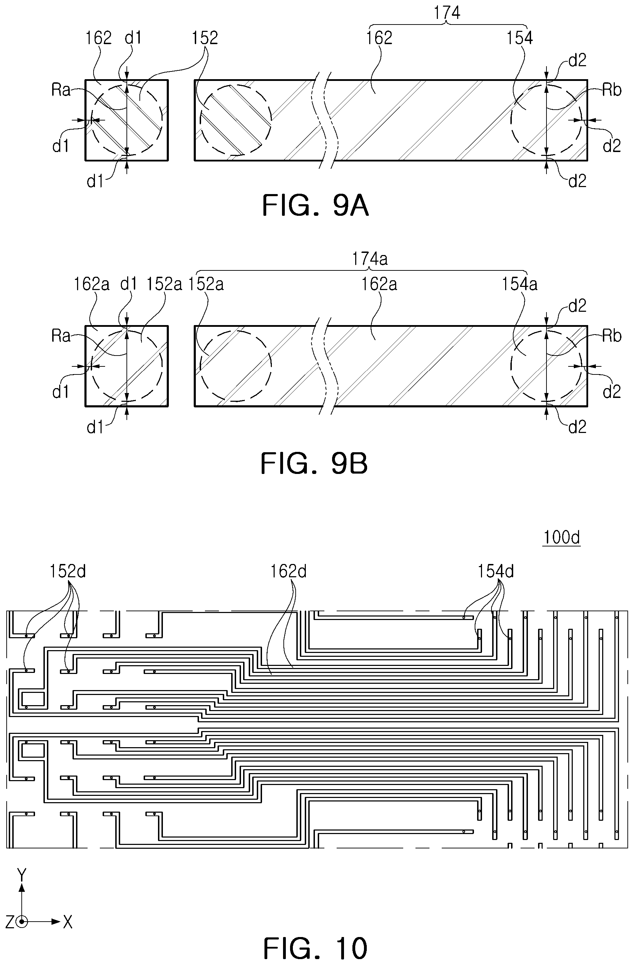

A side surface of the first connection portion 162 may be disposed in a more outward direction, compared to a side surface of the first contact plug 152 and a side surface of the second contact plug 154. A step difference may exist between the side surface of the first connection portion 162 and the side surface of the first contact plug 152, and between the side surface of the first connection portion 162 and the side surface of the second contact plug 154. The step difference between the first connection portion 162 and the second contact plug 154 will be described later with reference to FIG. 10.

A lower surface of the first connection portion 162 may be located on substantially the same level as an upper surface of the cell region insulating layer 190, but the present inventive concepts are not limited thereto. The lower surface of the first connection portion 162 may be located on a level, lower or higher than the upper surface of the cell region insulating layer 190. The upper surface of the first connection portion 162 may be located on substantially the same level as an upper surface of the third upper insulating layer 196. The upper surface of the first connection portion 162 may be located on substantially the same level as a lower surface of the bit line BL.

The first connection portion 162 may surround the first contact plug 152 by a first height H1, and the upper surface of the first connection portion 162 may be spaced apart from the lower surface of the first connection portion 162 by a second height H2. The first height H1 may be about 30 nm or more. The second height H2 may be equal to or greater than the first height H1, and may be equal to or less than about 500 nm. The second height H2 may be equal to or greater than about 30 nm and equal to or less than about 500 nm. The first height H1 and the second height H2 may have the above ranges to improve an operation speed without increasing resistance between the first contact plug 152 and the first connection portion 162.

The first connection portion 162 may include a line pattern electrically connecting the first contact plug 152 and the second contact plug 154, and, for example, connecting, at least, the first contact plug 152 and the second contact plug 154. The first contact plug 152 and the second contact plug 154 may be directly connected to each other by the first connection portion 162, and the second contact plug 154 may be integrally formed with the first connection portion 162. Therefore, when an electrical signal by a circuit element (220 in FIG. 1) is transmitted to the first contact plug 152 through the second contact plug 154 and the first connection portion 162, resistance due to an interface may be reduced and an operating speed of the semiconductor device 100 may be improved.

The first conductive pattern 174 and the first contact plug 152 may be formed of the same or different materials. In some example embodiments, the first conductive pattern 174 and the first contact plug 152 may be formed of tungsten (W), or the first conductive pattern 174 may be formed of polycrystalline silicon (Si) and the first contact plug 152 may be formed of tungsten (W). The barrier metal layer BM covering the surface of the first conductive pattern 174 may be formed of titanium (Ti) and titanium nitride (TiN), or may be formed of titanium nitride (TiN), but example embodiments are not limited thereto.

The above description may be equally or similarly applied to the first connection portion 162 connecting the first contact plug 152 and the second contact plug 156.

The second contact plug 156 may be integrally formed with the first connection portion 162 to form a second conductive pattern 176. Although a region to be connected is not illustrated in FIG. 2A, each of the second contact plugs 156 may be connected to each of the first contact plugs 152 by the first connection portion 162. An electrical signal may be transmitted to the first contact plug 152 through the second contact plug 156 and the first connection portion 162. Interface resistance in a path through which the electrical signal is transmitted may be reduced to improve a device speed.

The third contact plugs 158 may be connected to the second substrate 101 outside the second region R2. The third contact plugs 158 may be spaced apart from the gate electrodes 130. The third contact plugs 158 may pass through the cell region insulating layer 190 and may pass through upwardly exposed second horizontal conductive layer 104 and the horizontal insulating layer 110 therebelow, to be connected to the second substrate 101. The third contact plugs 158 may apply an electrical signal to, for example, a common source line including the second substrate 101.

A second connection portion 168 may connect a plurality of third contact plugs 158 to each other. The second connection portion 168 may be integrally formed with the plurality of third contact plugs 158 to form a third conductive pattern 178. The second connection portion 168 and the plurality of third contact plugs 158 may be formed of the same material, and an interface may not exist between the second connection portion 168 and the plurality of third contact plugs 158. The second connection portion 168 may have the same or similar height as the first connection portion 162.

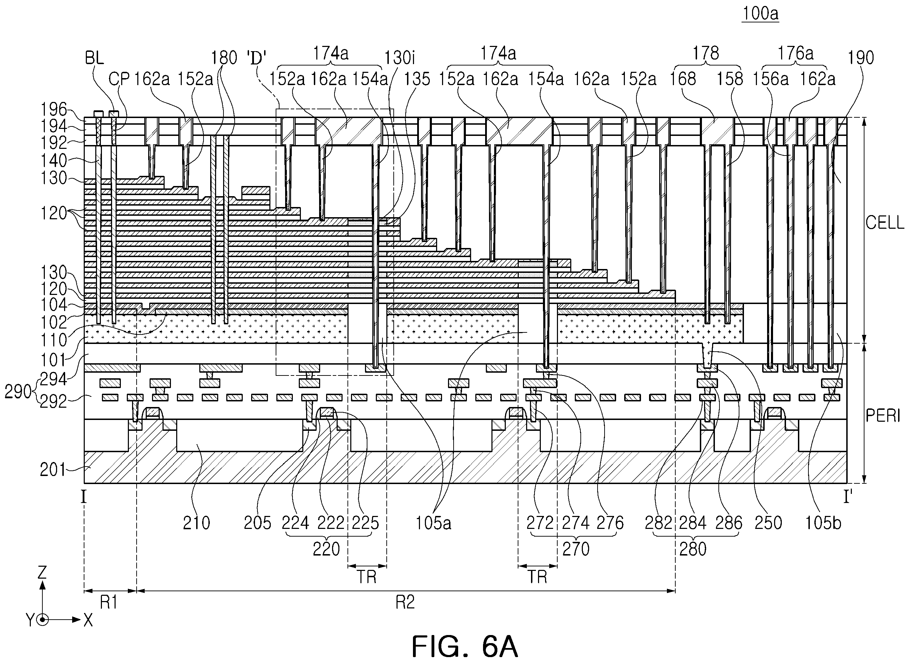

Embodiments of FIGS. 6A, 6B, and 7 to 10 illustrate a semiconductor device according to some example embodiments. In the example embodiments of FIGS. 6A, 6B and 7 to 10, in the case of having the same reference numerals as those of FIGS. 1 to 5 but different alphabets, example embodiments different from those of FIGS. 1 to 5 will be described. Features described with the same reference numerals described above may be the same or similar.

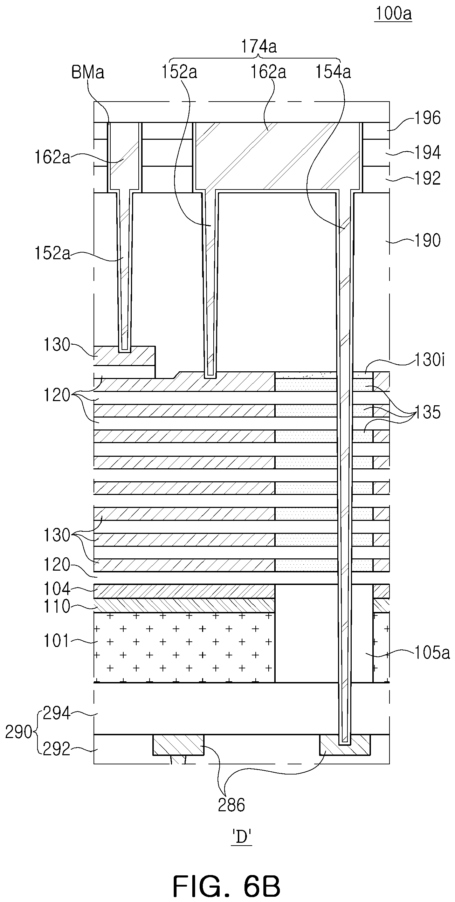

FIG. 6A is a schematic cross-sectional view of a semiconductor device according to some example embodiments, and FIG. 6B is a partially enlarged view of a semiconductor device according to some example embodiments. FIG. 6B illustrates an enlarged view of some configurations of portion 'D' in FIG. 6A.

A semiconductor device 100a illustrated in FIGS. 6A and 6B may be different from the semiconductor device 100 described above in view of the facts that a first contact plug 152a and a first connection portion 162a are integrally formed.

A first contact plug 152a, a first connection portion 162a, and a second contact plug 154a may be integrally formed to form a first conductive pattern 174a. The first contact plug 152a, the first connection portion 162a, and a second contact plug 156a may be integrally formed to form a second conductive pattern 176a. Since an interface does not exist between the first contact plug 152a, the first connection portion 162a, and the second contact plugs 154a and 156a, a transmission speed of an electrical signal may be further improved.

A barrier metal layer BMa may surround a surface of the first conductive pattern 174a and a surface of the second conductive pattern 176a. For example, the barrier metal layer BMa may surround an entire surface of the first conductive pattern 174a and an entire surface of the second conductive pattern 176a, except for upper surfaces thereof.

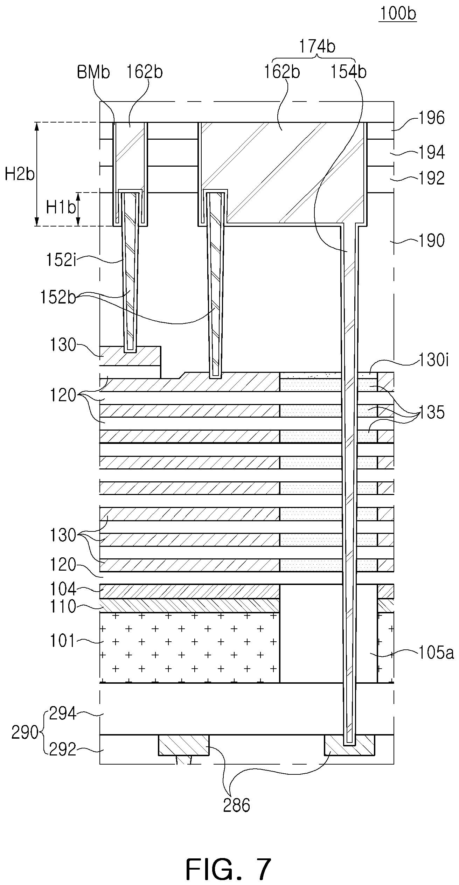

FIG. 7 is a partially enlarged view of a semiconductor device according to some example embodiments. In FIG. 7, a portion corresponding to the portion illustrated in FIG. 6B is illustrated.

A semiconductor device 100b illustrated in FIG. 7 may be different from the semiconductor device 100 described above in view of a height of a first contact plug 152b and a height of a first connection portion 162b.

The first contact plug 152b may pass through a cell region insulating layer 190. For example, an upper surface of the first contact plug 152b may extend to be located on substantially the same level as lower surfaces of upper insulating layers 192, 194, and 196.

A lower surface of the first connection portion 162b may be located on a level, lower than an upper surface of the cell region insulating layer 190, and an upper surface of the first connection portion 162b may be located on the substantially same level as an uppermost surface of the upper insulating layers 192, 194, and 196. The first connection portion 162b may surround the first contact plug 152b by a first height H1b, and the upper surface of the first connection portion 162b may be spaced apart from the lower surface of the first connection portion 162b by a second height H2b. The second height H2b may be equal to or greater than about 30 nm and equal to or less than about 500 nm. A first conductive pattern 174b may include the first connection portion 162b, and a second contact plug 154b. The semiconductor device 100b may include a barrier metal layer BMb.

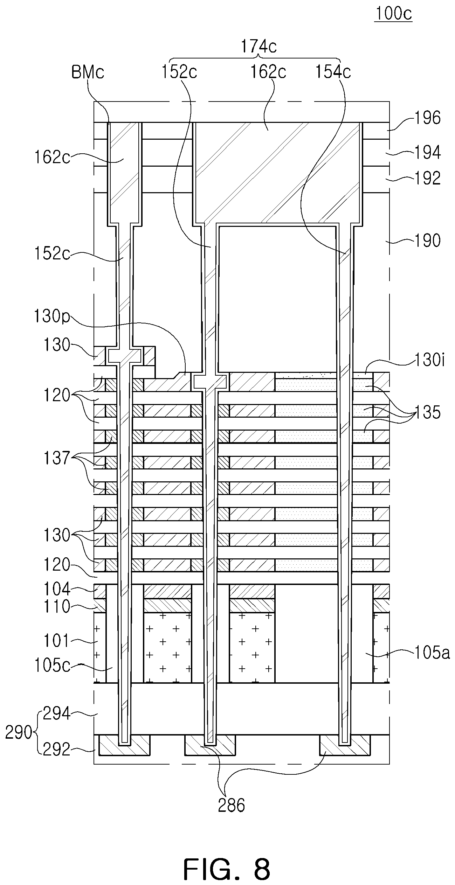

FIG. 8 is a partially enlarged view of a semiconductor device according to some example embodiments. In FIG. 8, a portion corresponding to the portion illustrated in FIG. 6B is illustrated.

A semiconductor device 100c illustrated in FIG. 8 may be different from the semiconductor device 100 described above in view of a shape of a first contact plug 152c.

The first contact plugs 152c may extend to pass through at least a portion of the cell region insulating layer 190, gate electrodes 130, interlayer insulating layers 120, a substrate insulating layer 105c, and a second peripheral region insulating layer 294, to be connected to the third lower interconnection lines 286. The first contact plugs 152c may pass through the gate electrodes 130 while passing through gate pads 130p of the gate electrodes 130, and may be electrically connected to the gate pads 130p while contacting the gate pads 130p. Each of the first contact plugs 152c may include a protrusion protruding from a portion contacting the gate pads 130p in a horizontal direction. The protrusions of the first contact plugs 152c may be in contact with the gate pads 130p.

The first contact plugs 152c may be in contact with the gate pads 130p, and may be spaced apart from other gate electrodes 130. For example, the first contact plugs 152c may be in contact with the gate pad 130p of any one of the gate layers, and may be spaced apart from gate layers located on a level, lower than a gate layer, by a buffer insulating layer 137.

A shape of the first contact plug 152c and a shape of a first connection portion 162c are not limited to those illustrated in FIG. 8. For example, although FIG. 8 illustrates an example embodiment in which the first contact plug 152c, the first connection portion 162c, and a second contact plug 154c are integrally formed to form a first conductive pattern 174c, the first contact plug 152c and the first connection portion 162c may be configured separately, as described above. In addition, the first contact plug 152c may extend onto a level, higher than an upper surface of the cell region insulating layer 190. The semiconductor device 100c may include a barrier metal layer BMc.

FIGS. 9A, 9B, and 10 are layout diagrams schematically illustrating a semiconductor device according to some example embodiments.

FIG. 9A is a layout view of the semiconductor device 100 of FIG. 4 as viewed from above, and FIG. 9B is a layout view of the semiconductor device 100a of FIG. 6B as viewed from above. In FIGS. 9A and 9B, only main configurations ae illustrated.

Referring to FIG. 9A, the first contact plug 152 may have a first diameter Ra, and the second contact plug 154 may have a second diameter Rb. The first connection portion 162 may have a first width, perpendicular or substantially perpendicular to a longitudinal direction thereof. In some example embodiments, the first width may be equal to or greater than the first diameter Ra and the second diameter Rb, respectively. For example, a side surface of the first connection portion 162 may be spaced apart from a side surface of the first contact plug 152 by a first distance d1, and may be spaced apart from a side surface of the second contact plug 154 by a second distance d2. The first distance d1 may be about 0.1 times or less of the first diameter Ra, and the second distance d2 may be about 0.1 times or less of the second diameter Rb. In one example, a line pattern comprised in a connection portion has a first width perpendicular to a longitudinal direction, the first width is equal to or greater than a diameter of each of the first contact plugs, and the first width is equal to or less than 1.2 times the diameter of each of the first contact plugs. In one example, a line pattern comprised in a connection portion has a first width perpendicular to a longitudinal direction, the first width is equal to or greater than a diameter of each of the second contact plugs, and the first width is equal to or less than 1.2 times the diameter of each of the second contact plugs.

As illustrated in FIG. 9B, the first contact plug 152a, the connection portion 162a, and the second contact plug 154a may be integrally formed to equally apply the above-described contents to an embodiment constituting the first conductive pattern 174a.

Shapes of the first connection portion 162 and the first and second contact plugs 152 and 154 are not limited to those illustrated in FIGS. 9A and 9B. In some example embodiments, the first connection portion 162 may have a first width in a region on which the first contact plug 152 and the second contact plug 154 land, and may have a second width, narrower than the first width, between the first contact plug 152 and the second contact plug 154. In addition, in some example embodiments, the first connection portion 162 may cover only a portion of upper surfaces of the first and second contact plugs 152 and 154. In addition, In some example embodiments, separation distances of the first contact plugs 152 and 152a and the second contact plugs 154 and 154a from side surfaces of the connection portions 162 and 162a may not be constant. Besides, shapes of the first connection portion 162 and the first and second contact plugs 152 and 154 may be variously changed according to a design rule.

FIG. 10 is a schematic layout view of a semiconductor device 100d as viewed from above. In FIG. 10, only main configurations ae illustrated.

As illustrated in FIG. 10, first connection portions 162d may connect one first contact plug 152d and one second contact plug 154d, respectively other. In example embodiments, the first connection portions 162d may be configured to connect a plurality of line patterns. Shapes of the first connection portions 162d are not limited thereto, and may be configured as a single line pattern, for example.

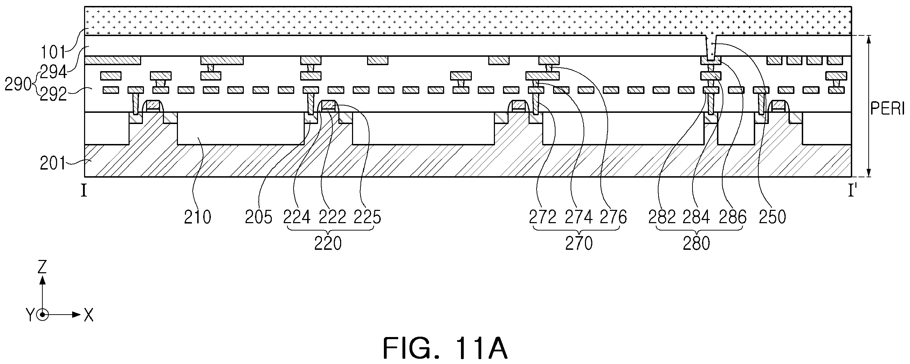

FIGS. 11A to 11I are schematic cross-sectional views illustrating a method of manufacturing a semiconductor device according to some example embodiments. FIGS. 11A to 11I, a portion corresponding to the portion illustrated in FIG. 2A is illustrated.

Referring to FIG. 11A, circuit elements 220 and a lower interconnection structure, constituting a peripheral circuit region PERI, may be formed on a first substrate 201.

First, device isolation layers 210 may be formed in a first substrate 201, and a circuit gate dielectric layer 222 and a circuit gate electrode 225 may be sequentially formed on the first substrate 201. The device isolation layers 210 may be, for example, formed by a shallow trench isolation (STI) process. The circuit gate dielectric layer 222 and the circuit gate electrode 225 may be formed using atomic layer deposition (ALD), chemical vapor deposition (CVD), etc. The circuit gate dielectric layer 222 may be formed of silicon oxide, and the circuit gate electrode 225 may be formed as at least one of a polycrystalline silicon layer or a metal silicide layer, but the present inventive concepts are not limited thereto. Next, a spacer layer 224 and impurity regions 205 may be formed on both sidewalls of the circuit gate dielectric layer 222 and both sidewalls of the circuit gate electrode 225. According to some example embodiments, the spacer layer 224 may include a plurality of layers. Next, an ion implantation process may be performed to form the impurity regions 205.

A lower contact plug 270 of a lower interconnection structure may be formed by partially forming a first peripheral region insulating layer 292, etching and removing a portion thereof, and then filling a conductive material in the removed portion of the first peripheral region insulating layer 292. Lower interconnection lines 280 may be formed by, for example, depositing a conductive material and then patterning the conductive material.

The first peripheral region insulating layer 292 may include a plurality of insulating layers. The first peripheral region insulating layer 292 may be partially formed in operations of forming the lower interconnection structure, respectively. A second peripheral region insulating layer 294 covering upper surfaces of third lower interconnection lines 286 may be disposed on the first peripheral region insulating layer 292. A lower protective layer may be additionally formed between the first peripheral region insulating layer 292 and the second peripheral region insulating layer 294. Therefore, a peripheral circuit region PERI may be entirely formed.

Hereinafter, to form a ground via 250, a via hole extending from an upper surface of the second peripheral region insulating layer 294 to the third lower interconnection lines 286 may be formed. The via hole may be filled with a material constituting a second substrate 101, and the second substrate 101 may be formed thereon. Therefore, the ground via 250 may be formed. The ground via 250 and the second substrate 101 may be formed of, for example, polycrystalline silicon, and may be formed by a CVD process.

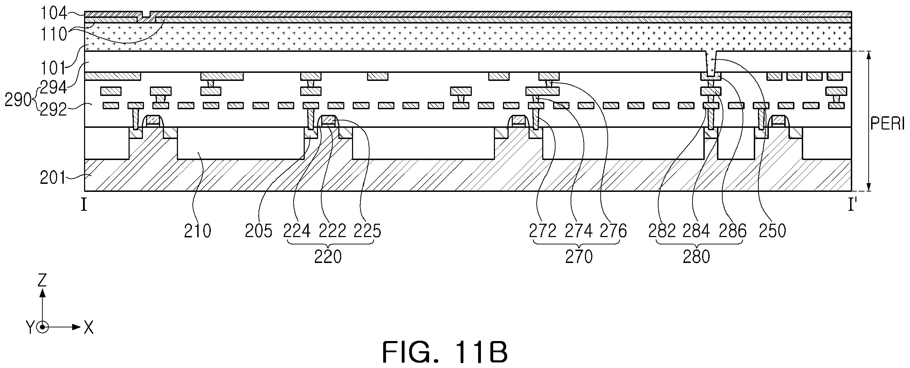

Referring to FIG. 11B, a horizontal insulating layer 110 and a second horizontal conductive layer 104 may be formed on the second substrate 101.

The horizontal insulating layer 110 may be stacked on the second substrate 101. The horizontal insulating layer 110 may be a layer partially replaced with the first horizontal conductive layer (102 in FIG. 2A) by a subsequent process. A portion of the horizontal insulating layer 110, for example, in a first region (R1 in FIG. 2A) of the second substrate 101 may be removed by a patterning process.

The second horizontal conductive layer 104 may be formed on the horizontal insulating layer 110, and may be in contact with the second substrate 101 in a portion from which the horizontal insulating layer 110 is removed. Therefore, the second horizontal conductive layer 104 may be bent along end portions of the horizontal insulating layer 110, may cover the end portions, and may extend onto the second substrate 101.

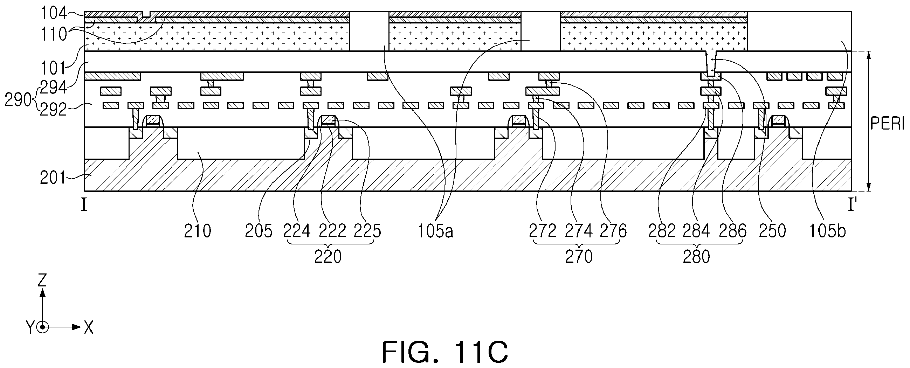

Referring to FIG. 11C, a substrate structure of the second substrate 101, the horizontal insulating layer 110, and the second horizontal conductive layer 104 may be patterned to form substrate insulating layers 105a and 105b.

The substrate structure including the second substrate 101 may be partially removed from a second region R2. In particular, the substrate structure may be partially removed in a region in which a through-insulating region (TR in FIG. 2A) is located.

The substrate insulating layers 105a and 105b may be formed by filling an insulating material in the portion from which the substrate structure has been removed. After the insulating material is deposited on the second horizontal conductive layer 104, the insulating material may be planarized by a planarization process such as chemical mechanical planarization (CMP) to form the substrate insulating layers 105a and 105b. Regions in which the substrate insulating layers 105a and 105b are formed may be defined as the through-insulating region (TR in FIG. 2A).

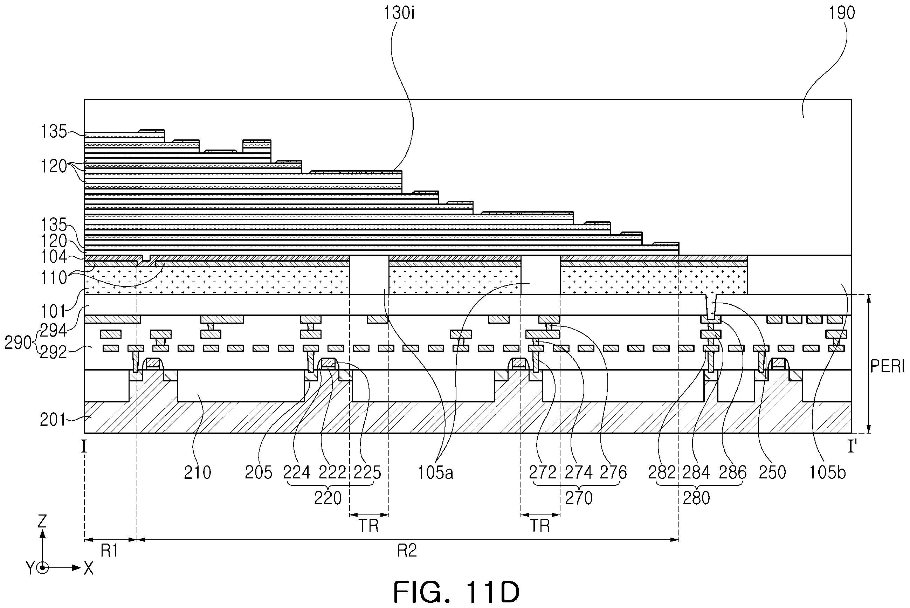

Referring to FIG. 11D, sacrificial insulating layers 135 and interlayer insulating layers 120 may be alternately stacked to form a preliminary stack structure and a cell region insulating layer 190.

On one side of the preliminary stack structure, the sacrificial insulating layers 135 and the interlayer insulating layers 120 may include pad regions arranged in a step shape. In the preliminary stack structure, a region in which the pad regions in which the sacrificial insulating layers 135 and the interlayer insulating layers 120 are arranged in a step shape are located may be defined as a second region R2, and a region in which the sacrificial insulating layers 135 and the interlayer insulating layers 120 are located in a region adjacent to the second region R2 may be defined as a first region R1. The interlayer insulating layers 120 may be formed of silicon oxide, and the sacrificial insulating layers 135 may be formed of silicon nitride.

After forming the preliminary stack structure, reinforcing horizontal layers 130i may be formed on regions of the sacrificial insulating layers 135 arranged in a step shape. The reinforcing horizontal layers 130i may be formed of silicon nitride. Thereafter, the cell region insulating layer 190 covering the preliminary stack structure and the reinforcing horizontal layers 130i may be formed.

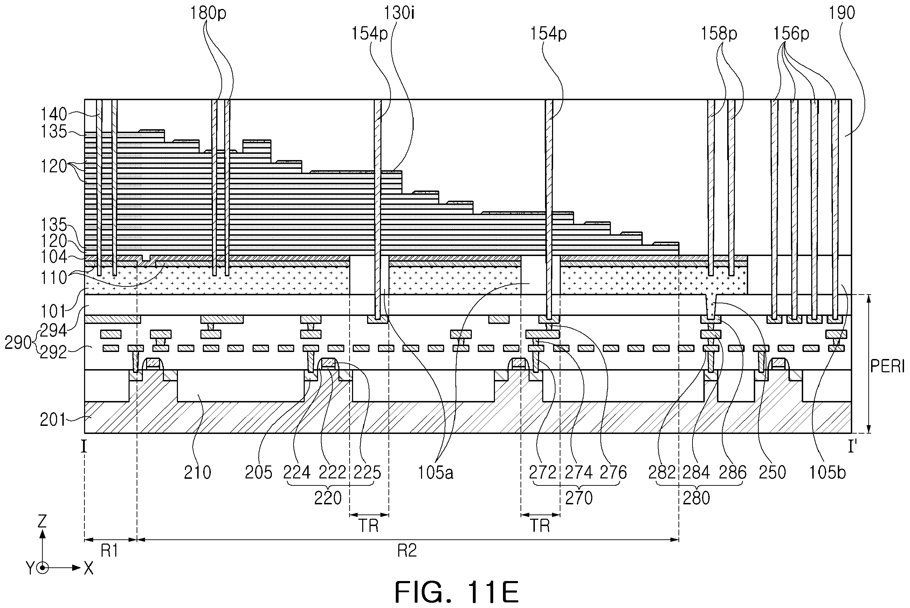

Referring to FIG. 11E, channel structures 140, preliminary support vertical structures 180p, preliminary second contact plugs 154p and 156p, and preliminary third contact plugs 158p, passing through the preliminary stack structure, may be formed.

First, channel structures 140 passing through the preliminary stack structures and contacting the second substrate 101 may be formed in the first region R1. As described with reference to FIG. 5, the channel structures 140 may include a channel layer (e.g., 141 in FIG. 5), a tunneling layer (e.g., 142 in FIG. 5), a charge storage layer (e.g., 143 in FIG. 5), a blocking layer (e.g., 144 in FIG. 5), a channel buried insulating layer (e.g., 145 in FIG. 5), and a channel pad (e.g., 146 in FIG. 5).

Hereinafter, the second preliminary contact plugs 154p and 156p and the third preliminary contact plugs 158p may be formed. Holes in which the second preliminary contact plugs 154p and 156p and the third preliminary contact plugs 158p are formed may be formed simultaneously or substantially simultaneously, and each of the holes may be filled with a sacrificial material, for example polycrystalline silicon. The second preliminary contact plugs 154p may pass through the cell region insulating layer 190, the preliminary stack structure, the substrate insulating layer 105a, and the second peripheral region insulating layer 294, to be connected to the lower interconnection structure. The second preliminary contact plugs 156p may pass through the cell region insulating layer 190, the substrate insulating layer 105b, and the second peripheral region insulating layer 294, to be connected to the lower interconnection structure. The third preliminary contact plugs 158p may pass through the cell region insulating layer 190, the second horizontal conductive layer 104, and the horizontal insulating layer 110, to contact the second substrate 101. The preliminary support vertical structures 180p may pass through the cell region insulating layer 190, the preliminary stack structure, the second horizontal conductive layer 104, and the horizontal insulating layer 110, to contact the second substrate 101.

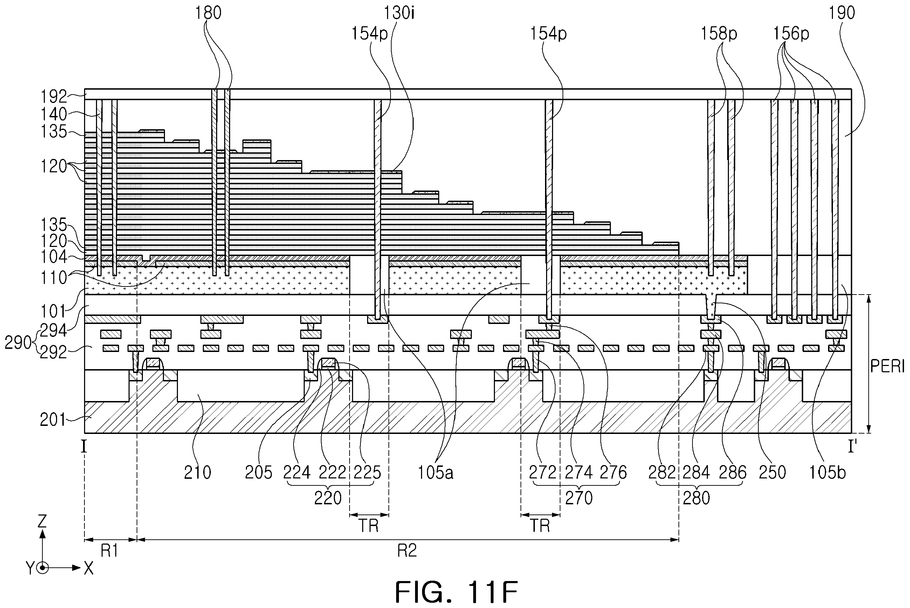

Referring to FIG. 11F, a first upper insulating layer 192 may be formed on the cell region insulating layer 190, and a support vertical structure 180 may be formed.

First, a first upper insulating layer 192 covering an upper surface of the cell region insulating layer 190 may be formed on the cell region insulating layer 190. The first upper insulating layer 192 may have a substitution pattern of a shape corresponding to upper surfaces of the preliminary support vertical structures (180p in FIG. 11E). The substitution pattern of the upper insulating layer 192 may be bonded to the preliminary support vertical structures (180p in FIG. 11E), a sacrificial material of the preliminary support vertical structures (180p in FIG. 11E) may be removed through the substitution pattern, and holes of the preliminary support vertical structures and the substitution pattern of the upper insulating layer 192 may be filled with silicon oxide. Thereby, a support vertical structure 180 may be formed.

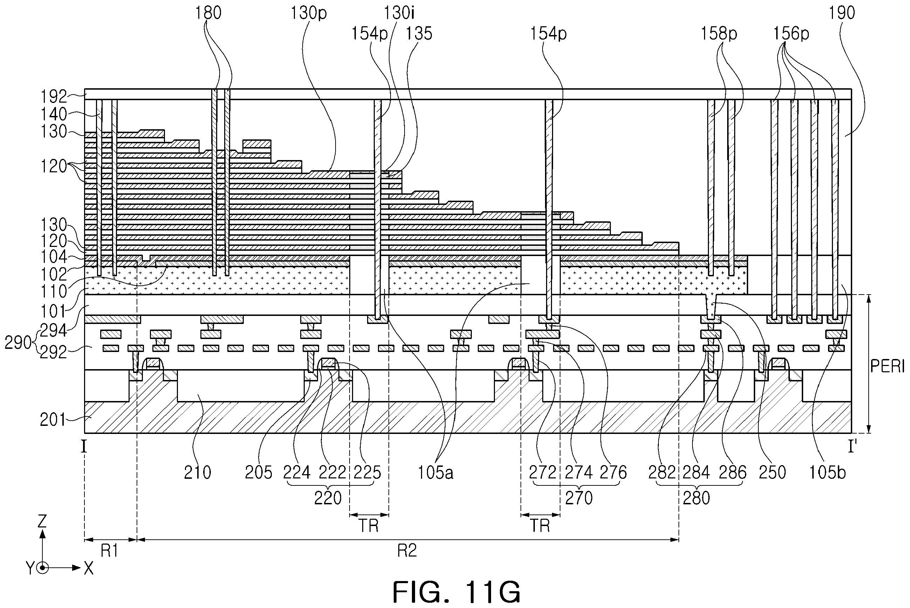

Referring to FIG. 11G, a portion of the sacrificial insulating layers 135 of the preliminary stack structures may be replaced with gate electrodes 130.

Referring to FIGS. 1 and 11G together, isolation trenches sequentially passing through the first upper insulating layer 192 and the preliminary stack structure and extending into the second substrate 101 may be formed. The isolation trenches may be regions corresponding to isolation regions (e.g., MS in FIG. 1). The isolation trenches may expose the horizontal insulating layer (e.g., 110 in FIG. 11F) in a lower portion of the region R1, and may be spaced apart from the horizontal insulating layer 110 in a lower portion of the second region R2. After removing the horizontal insulating layer (e.g., 110 in FIG. 11F) in a lower portion of the first region R1 exposed by the isolation trenches, a first horizontal conductive layer 102 may be formed in the removed space. The first horizontal conductive layer 102 may be formed as a polycrystalline silicon layer having N-type conductivity.

The sacrificial insulating layers 135 of the preliminary stack structure exposed by the isolation trenches may be partially etched to form empty spaces, and gate electrodes 130 may be formed in the empty spaces. In some example embodiments, before forming the gate electrodes 130, a gate dielectric layer (e.g., 130a in FIG. 3) may be conformally formed. The preliminary stack structure may be replaced with a stack structure including the interlayer insulating layers 120 and the gate electrodes 130. The reinforcing horizontal layers (e.g., 130i in FIG. 11F) may be also replaced with the gate electrodes 130, to form gate pads 130p.

A portion of the sacrificial insulating layers 135 may remain without being etched. Regions in which the sacrificial insulating layers 135 are formed in the stack structure may be defined as through-insulating regions TR.

Hereinafter, isolation regions MS may be formed in the isolation trenches. The isolation regions MS may be formed of silicon oxide.

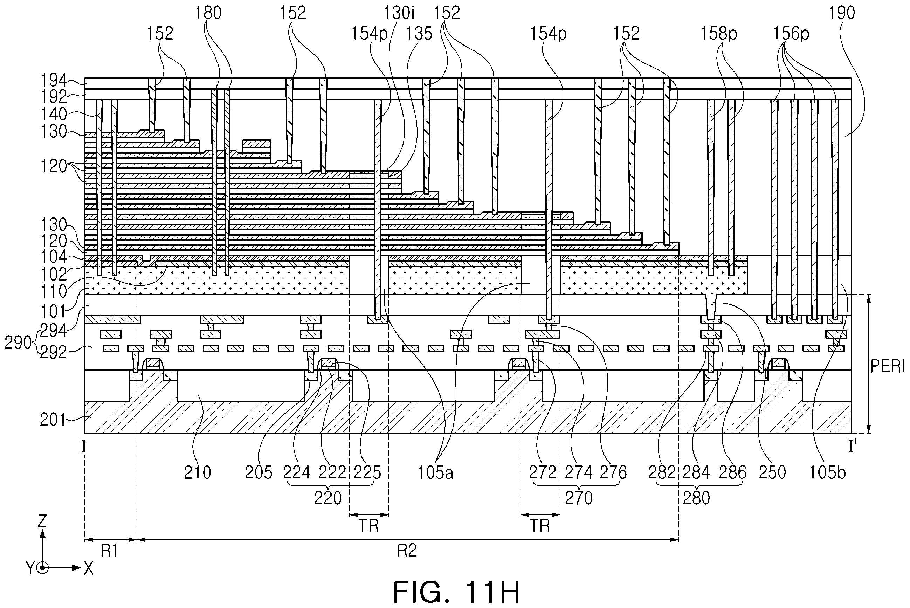

Referring to FIG. 11H, a second upper insulating layer 194 may be formed on the first upper insulating layer 192, and first contact plugs 152 may be formed.

The first contact plugs 152 may pass through the first and second upper insulating layers 192 and 194 and the cell region insulating layer 190 to contact the gate pads of the gate electrodes 130.

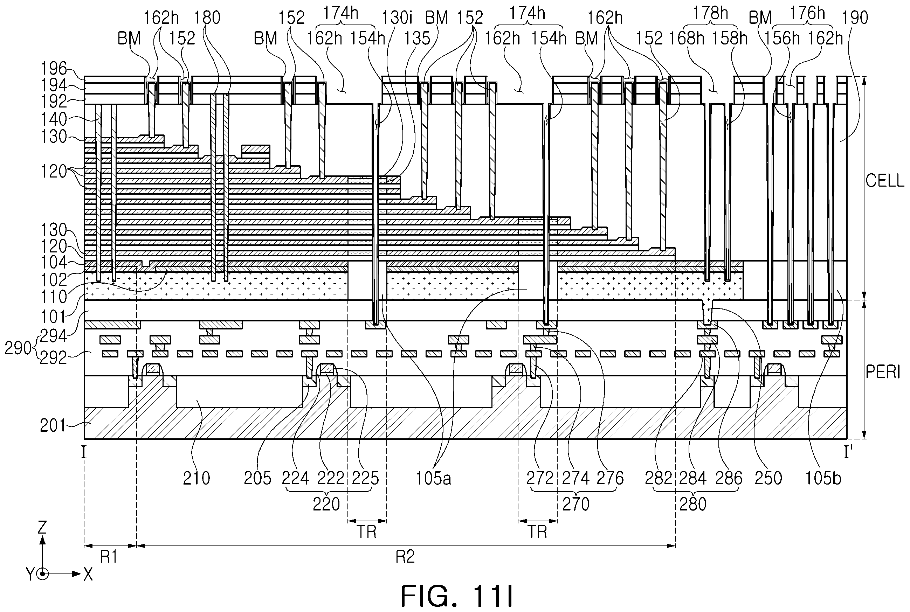

Referring to FIG. 11I, a third upper insulating layer 196 may be formed on the second upper insulating layer 194, and first to third conductive pattern holes 174h, 176h, and 178h may be formed.

First, a third upper insulating layer 196 covering an upper surface of the second upper insulating layer 194 may be formed on the second upper insulating layer 194. The third upper insulating layer 196 may include first substitution patterns connecting the first contact plug 152 and the second preliminary contact plug (e.g., 154p in FIG. 11H), or the first contact plug 152 and the second preliminary contact plug (e.g., 156p in FIG. 11H). The third upper insulating layer 196 may include second substitution patterns connecting the plurality of third preliminary contact plugs (158p in FIG. 11H).

The first substitution patterns may be bonded to the first contact plug 152 and the second preliminary contact plugs (e.g., 154p and 156p in FIG. 11H), the second substitution patterns may be bonded to the third preliminary contact plugs (e.g., 158p in FIG. 11H), and a portion of the first and second upper insulating layers 192 and 194 and sacrificial materials of the second and third preliminary contact plugs (e.g., 154p, 156p, and 158p in FIG. 11H) may be removed through the first and second substitution patterns.

Thereby, first and second connection portion holes 162h and 168h, second contact plug holes 154h and 156h, and third contact plug holes 158h, passing through the first to third upper insulating layers 192, 194, and 196, may be formed. The first connection portion hole 162h and the second contact plug hole 154h may form a continuous empty space to constitute a first conductive pattern hole 174h. The first connection portion hole 162h and the second contact plug hole 156h may form a continuous empty space to constitute a second conductive pattern hole 176h. The second connection portion hole 168h and the third contact plug holes 158h may form a continuous empty space to constitute a third conductive pattern hole 178h.

Hereinafter, a barrier metal layer BM covering surfaces of the first to third conductive pattern holes 174h, 176h, and 178h may be formed. The barrier metal layer BM may be conformally formed on the surfaces of the first to third conductive pattern holes 174h, 176h, and 178h, and may be formed, for example, using at least one method of atomic layer deposition (ALD), chemical vapor deposition (CVD), physical vapor deposition (PVD), or low pressure chemical vapor deposition (LPCVD), but the present inventive concepts are not limited thereto.

Hereinafter, referring back to Figs. 1 to 5, first to third conductive patterns 174, 176, and 178 may be formed, and upper contact plugs CP and bit lines BL may be formed on the channel structures 140.

The first to third conductive pattern holes (e.g., 174h, 176h, and 178h in FIG. 11I) may be filled with a conductive material, for example, tungsten (W), polycrystalline silicon, or the like. Thereby, first to third conductive patterns 174, 176, and 178 may be formed. Upper surfaces of the first to third conductive patterns 174, 176, and 178 may be located on substantially the same level as an uppermost surface of the upper insulating layers 192, 194, and 196.

Upper contact plugs CP passing through the upper insulating layers 192, 194, and 196 may be formed on the channel structures 140. Then, bit lines BL respectively connected to the upper contact plugs CP may be formed on the upper insulating layers 192, 194, and 196. A formation order of the upper contact plugs CP and the bit lines BL may be changed. For example, as in FIG. 11I, after the third upper insulating layer 196 is formed, and before the first to third conductive pattern holes 174h, 176h, and 178h are formed, it is also possible to form the upper contact plugs CP and the bit lines BL.

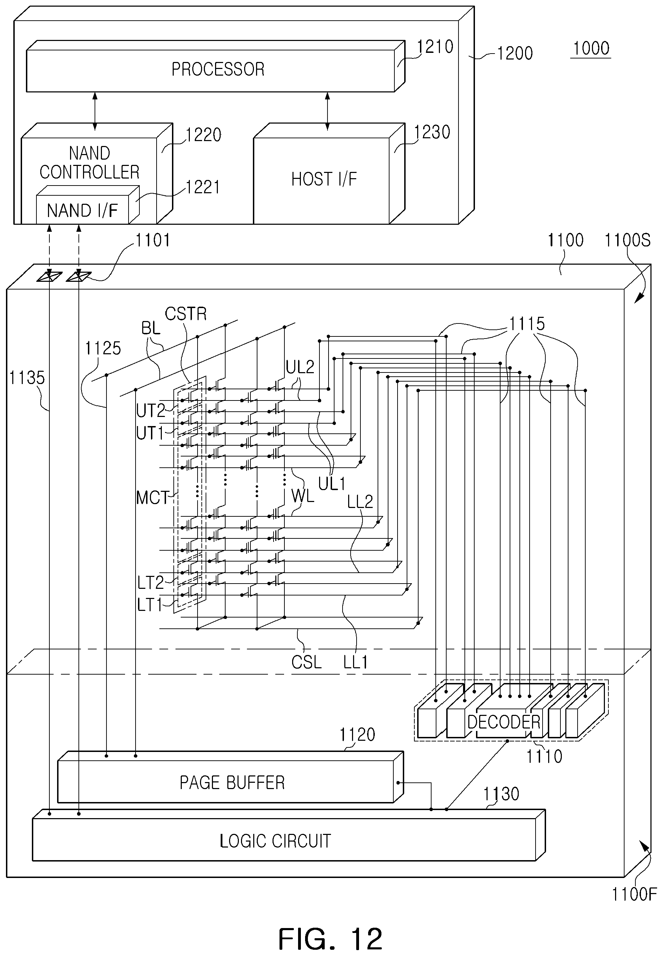

FIG. 12 is a view schematically illustrating an electronic system including a semiconductor device according to some example embodiments.

Referring to FIG. 12, an electronic system 1000 may include a semiconductor device 1100, and a controller 1200 electrically connected to the semiconductor device 1100. The electronic system 1000 may be a storage device including the semiconductor device 1100 as a single semiconductor device or a plurality of semiconductor devices, or an electronic device including the storage device. For example, the electronic system 1000 may be a solid state drive device (SSD), a universal serial bus (USB), a computing system, a medical device, or a communication device, including the semiconductor device 1100 as a single semiconductor device or a plurality of semiconductor devices.

The semiconductor device 1100 may be a non-volatile memory device, for example, a NAND flash memory device according to any one of the embodiments described above with reference to FIGS. 1 to 12. The semiconductor device 1100 may include a first semiconductor structure 1100F, and a second semiconductor structure 1100S on the first semiconductor structure 1100F. In some example embodiments, the first semiconductor structure 1100F may be disposed next to the second semiconductor structure 1100S. The first semiconductor structure 1100F may be a peripheral circuit structure including a decoder circuit 1110, a page buffer 1120, and a logic circuit 1130. The second semiconductor structure 1100S may be a memory cell structure including bit lines BL, a common source line CSL, word lines WL, first and second upper gate lines UL1 and UL2, first and second lower gate lines LL1 and LL2, and memory cell strings CSTR between each of the bit lines BL and the common source line CSL.

In the second semiconductor structure 1100S, each of the memory cell strings CSTR may include lower transistors LT1 and LT2 adjacent to the common source line CSL, upper transistors UT1 and UT2 adjacent to each of the bit lines BL, and a plurality of memory cell transistors MCT disposed between each of the lower transistors LT1 and LT2 and each of the upper transistors UT1 and UT2. The number of lower transistors LT1 and LT2 and the number of upper transistors UT1 and UT2 may be variously changed according to example embodiments.

In some example embodiments, each of the upper transistors UT1 and UT2 may include a string select transistor, and each of the lower transistors LT1 and LT2 may include a ground select transistor. The lower gate lines LL1 and LL2 may be gate electrodes of the lower transistors LT1 and LT2, respectively. The word lines WL may be gate electrodes of the memory cell transistors MCT, and the upper gate lines UL1 and UL2 may be gate electrodes of the upper transistors UT1 and UT2, respectively.

In some example embodiments, the lower transistors LT1 and LT2 may include a lower erase control transistor LT1 and a ground select transistor LT2, connected in series. The upper transistors UT1 and UT2 may include a string select transistor UT1 and an upper erase control transistor UT2, connected in series. At least one of the lower erase control transistor LT1 or the upper erase control transistor UT2 may be used for an erase operation of erasing data stored in the memory cell transistors MCT using a gate-induced-drain-leakage (GIDL) phenomenon.

The common source line CSL, the first and second lower gate lines LL1 and LL2, the word lines WL, and the first and second upper gate lines UL1 and UL2 may be electrically connected to the decoder circuit 1110 through first connection interconnections 1115 extending from the first semiconductor structure 1100F into the second semiconductor structure 1100S. The bit lines BL may be electrically connected to the page buffer 1120 through second connection interconnections 1125 extending from the first semiconductor structure 1100F into the second semiconductor structure 1100S.

In the first semiconductor structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through an input/output pad 1101 electrically connected to the logic circuit 1130. The input/output pad 1101 may be electrically connected to the logic circuit 1130 through input/output connection interconnections 1135 extending from the first semiconductor structure 1100F into the second semiconductor structure 11005.

The controller 1200 may include a processor 1210, a NAND controller 1220, and a host interface 1230. According to some example embodiments, the electronic system 1000 may include a plurality of semiconductor devices 1100, and in this case, the controller 1200 may control the plurality of semiconductor devices 1100.

The processor 1210 may control an overall operation of the electronic system 1000 including the controller 1200. The processor 1210 may operate according to a predetermined firmware, and may access to the semiconductor device 1100 by controlling the NAND controller 1220. The NAND controller 1220 may include a controller interface 1221 processing communications with the semiconductor device 1100. A control command for controlling the semiconductor device 1100, data to be written to the memory cell transistors MCT of the semiconductor device 1100, data to be read from the memory cell transistors MCT of the semiconductor device 1100, or the like may be transmitted through the controller interface 1221. The host interface 1230 may provide a communication function between the electronic system 1000 and an external host. When a control command is received from the external host through the host interface 1230, the processor 1210 may control the semiconductor device 1100 in response to the control command.

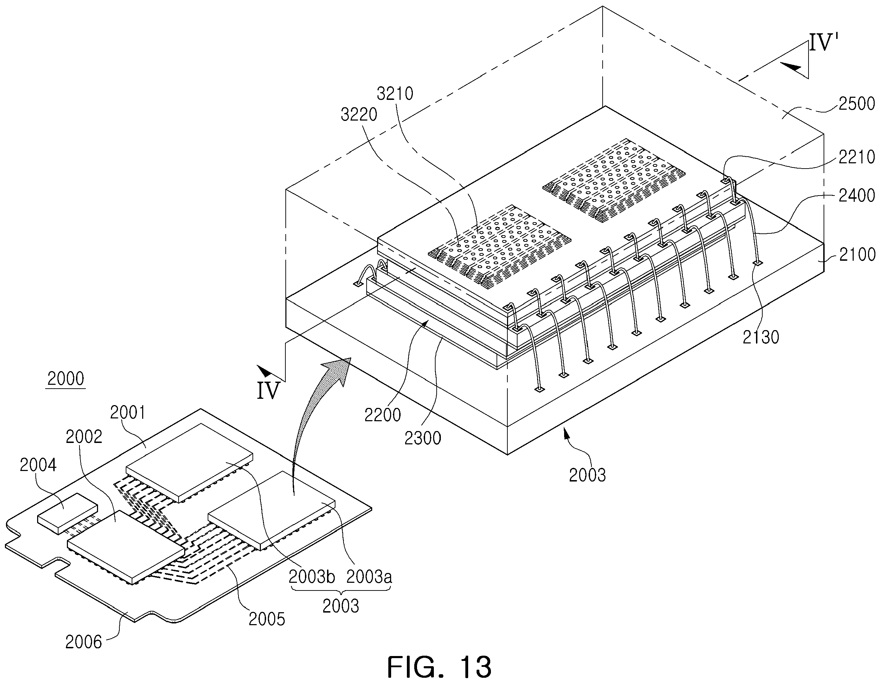

FIG. 13 is a perspective view schematically illustrating an electronic system including a semiconductor device according to some example embodiments.

Referring to FIG. 13, an electronic system 2000 according to an example embodiment of the present inventive concept may include a main substrate 2001, a controller 2002 mounted on the main substrate 2001, at least one semiconductor package 2003, and a DRAM 2004. The semiconductor package 2003 and the DRAM 2004 may be connected to the controller 2002 by wiring patterns 2005 formed on the main substrate 2001.

The main substrate 2001 may include a connector 2006 including a plurality of pins, which may be coupled to an external host. The number and an arrangement of the plurality of pins in the connector 2006 may vary according to a communication interface between the electronic system 2000 and the external host. In example embodiments, the electronic system 2000 may be communicated with the external host according to any one interface of a universal serial bus (USB), peripheral component interconnect express (PCI-Express), serial advanced technology attachment (SATA), M-Phy for universal flash storage (UFS), or the like. In some example embodiments, the electronic system 2000 may be operated by power supplied from the external host through the connector 2006. The electronic system 2000 may further include a power management integrated circuit (PMIC) distributing power, supplied from the external host, to the controller 2002 and the semiconductor package 2003.

The controller 2002 may write data to the semiconductor package 2003 or read data from the semiconductor package 2003, and may improve an operation speed of the electronic system 2000.

The DRAM 2004 may be a buffer memory reducing a difference in speed between the semiconductor package 2003, which may be a data storage space, and the external host. The DRAM 2004 included in the electronic system 2000 may also operate as a type of cache memory, and may provide a space temporarily storing data in a control operation on the semiconductor package 2003. When the DRAM 2004 is included in the electronic system 2000, the controller 2002 may further include a DRAM controller controlling the DRAM 2004 in addition to a NAND controller controlling the semiconductor package 2003.

The semiconductor package 2003 may include first and second semiconductor packages 2003a and 2003b, spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on a lower surface of each of the semiconductor chips 2200, a connection structure 2400 electrically connecting each of the semiconductor chips 2200 and the package substrate 2100, and a molding layer 2500 covering the semiconductor chips 2200 and the connection structure 2400 on the package substrate 2100.

The package substrate 2100 may be a printed circuit board including package upper pads 2130. Each of the semiconductor chips 2200 may include an input/output pad 2210. The input/output pad 2210 may correspond to the input/output pad 1101 of FIG. 12. Each of the semiconductor chips 2200 may include stack structures 3210 and channel structures 3220. Each of the semiconductor chips 2200 may include the semiconductor device described above with reference to FIGS. 1 to 10.

In some example embodiments, the connection structure 2400 may be a bonding wire electrically connecting the input/output pad 2210 and the upper package pads 2130. Therefore, in each of the first and second semiconductor packages 2003a and 2003b, the semiconductor chips 2200 may be electrically connected to each other by a bonding wire process, and may be electrically connected to the package upper pads 2130 of the package substrate 2100. According to some example embodiments, in each of the first and second semiconductor packages 2003a and 2003b, the semiconductor chips 2200 may be electrically connected to each other by a connection structure including a through silicon via (TSV), instead of a connection structure 2400 by a bonding wire process.

In some example embodiments, the controller 2002 and the semiconductor chips 2200 may be included in one (1) package. In an example embodiment, the controller 2002 and the semiconductor chips 2200 may be mounted on a separate interposer substrate, different from the main substrate 2001, and the controller 2002 and the semiconductor chips 2200 may be connected to each other by a wiring formed on the interposer substrate.

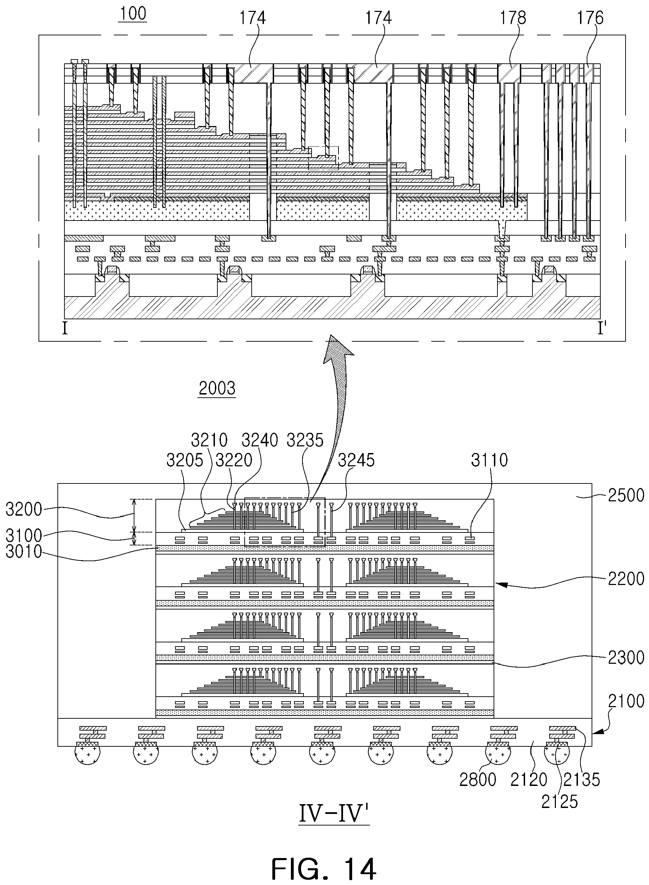

FIG. 14 is a cross-sectional view schematically illustrating a semiconductor package according to some example embodiments. FIG. 14 illustrates an example embodiment of the semiconductor package 2003 of FIG. 13, and conceptually illustrates a region taken along line IV-IV' of the semiconductor package 2003 of FIG. 13.

Referring to FIG. 14, in the semiconductor package 2003, the package substrate 2100 may be a printed circuit board. The package substrate 2100 may include a package substrate body portion 2120, package upper pads 2130 (refer to FIG. 13) disposed on an upper surface of the package substrate body portion 2120, lower pads 2125 disposed on a lower surface of the package substrate body portion 2120 or exposed from the lower surface, and internal interconnections 2135 electrically connecting the upper pads 2130 and the lower pads 2125 in the package substrate body portion 2120. The upper pads 2130 may be electrically connected to the connection structures 2400. The lower pads 2125 may be connected to the wiring patterns 2005 of the main substrate 2001 of the electronic system 2000, as illustrated in FIG. 13, through conductive connection portions 2800.

Each of the semiconductor chips 2200 may include a semiconductor substrate 3010, and a first semiconductor structure 3100 and a second semiconductor structure 3200, sequentially stacked on the semiconductor substrate 3010. The first semiconductor structure 3100 may include a peripheral circuit region including peripheral interconnections 3110. The second semiconductor structure 3200 may include a common source line 3205, a stack structure 3210 on the common source line 3205, channel structures 3220 and isolation regions, passing through the stack structure 3210, bit lines 3240 electrically connected to the channel structures 3220, and contact plugs 3235 electrically connected to the word lines WL (refer to FIG. 12) of the stack structure 3210. As described above with reference to FIGS. 1 to 10, each of the semiconductor chips 2200 may include a contact plug and conductive patterns 174, 176, and 178 including a connection portion integrally formed with the contact plug.

Each of the semiconductor chips 2200 may include a through-interconnection 3245 electrically connected to the peripheral interconnections 3110 of the first semiconductor structure 3100 and extending into the second semiconductor structure 3200. The through-interconnection 3245 may be disposed outside the stack structure 3210, and may be further disposed to pass through the stack structure 3210. Each of the semiconductor chips 2200 may further include an input/output pad (2210 in FIG. 13) electrically connected to the peripheral wirings 3110 of the first semiconductor structure 3100.

According to some embodiments of the present inventive concepts, a through-contact plug and a connection portion connecting the through-contact plug and a gate contact plug may be integrally configured (e.g., integral with one another) to provide a semiconductor device and an electronic system having improved operating speed and reliability.

Various advantages and effects of the present inventive concepts are not limited to the above, and will be more easily understood in the process of describing example embodiments of the present inventive concepts.

Elements and/or properties thereof (e.g., structures, surfaces, directions, or the like) that are "substantially perpendicular" with regard to other elements and/or properties thereof will be understood to be "perpendicular" with regard to the other elements and/or properties thereof within manufacturing tolerances and/or material tolerances and/or have a deviation in magnitude and/or angle from "perpendicular," or the like with regard to the other elements and/or properties thereof that is equal to or less than 10% (e.g., a. tolerance of ±10%).

Elements and/or properties thereof (e.g., structures, surfaces, directions, or the like) that are "substantially parallel" with regard to other elements and/or properties thereof will be understood to be "parallel" with regard to the other elements and/or properties thereof within manufacturing tolerances and/or material tolerances and/or have a deviation in magnitude and/or angle from "parallel," or the like with regard to the other elements and/or properties thereof that is equal to or less than 10% (e.g., a. tolerance of ±10%).

Elements and/or properties thereof (e.g., structures, surfaces, directions, or the like) that are "substantially coplanar" with regard to other elements and/or properties thereof will be understood to be "coplanar" with regard to the other elements and/or properties thereof within manufacturing tolerances and/or material tolerances and/or have a deviation in magnitude and/or angle from "coplanar," or the like with regard to the other elements and/or properties thereof that is equal to or less than 10% (e.g., a. tolerance of ±10%)).

It will be understood that elements and/or properties thereof described herein as being "substantially" the same and/or identical encompasses elements and/or properties thereof that have a relative difference in magnitude that is equal to or less than 10%. Further, regardless of whether elements and/or properties thereof are modified as "substantially," it will be understood that these elements and/or properties thereof should be construed as including a manufacturing or operational tolerance (e.g., ±10%) around the stated elements and/or properties thereof.

One or more of the elements disclosed above may include or be implemented in one or more processing circuitries such as hardware including logic circuits; a hardware/software combination such as a processor executing software; or a combination thereof. For example, the processing circuitries more specifically may include, but is not limited to, a central processing unit (CPU), an arithmetic logic unit (ALU), a digital signal processor, a microcomputer, a field programmable gate array (FGPA), a System-on-Chip (SoC), a programmable logic unit, a microprocessor, application-specific integrated circuit (ASIC), etc.

While some example embodiments have been illustrated and described above, it will be apparent to those skilled in the art that modifications and variations could be made without departing from the scope of the present inventive concepts.

## Claims

1. A semiconductor device comprising:
a first semiconductor structure including a first substrate, circuit elements on the first substrate, and lower interconnection lines electrically connected to the circuit elements; and
a second semiconductor structure on the first semiconductor structure,
wherein the second semiconductor structure includes:
a second substrate including a first region and a second region,
gate electrodes stacked on the second substrate, the gate electrodes spaced apart from each other in a first direction,
interlayer insulating layers alternately stacked with the gate electrodes,
through-insulating regions passing through the gate electrodes in the second region, the through-insulating regions extending in a second direction,
a capping insulating layer covering the gate electrodes and the interlayer insulating layers,
an upper insulating layer on the capping insulating layer,
channel structures passing through the capping insulating layer and the gate electrodes in the first region, each of the channel structures extending in the first direction and including a channel layer,
upper contact plugs passing through the upper insulating layer, each of the upper contact plugs connected to at least one of the channel structures,
bit lines on the upper insulating layer, each of the bit lines connected to at least one of the upper contact plugs,
first contact plugs passing through the capping insulating layer in the second region, each of the first contact plugs extending in the first direction and electrically connected to at least one of the gate electrodes, and
conductive patterns including second contact plugs passing through each of the through-insulating regions in the second region, the second contact plugs extending in the first direction and electrically connected to the lower interconnection lines, and the conductive patterns including connection portions integral with the second contact plugs, the connection portions extending to surround an upper surface and at least a portion of a side surface of at least one of the first contact plugs.

2. The semiconductor device of claim 1, further comprising a barrier metal layer surrounding an entire surface of each of the conductive patterns except for an upper surface of each of the conductive patterns.

3. The semiconductor device of claim 2, wherein the barrier metal layer includes a portion between the connection portions and the first contact plugs.

4. The semiconductor device of claim 2 or 3, wherein:
the conductive patterns comprise at least one of tungsten (W) and polycrystalline silicon,
the first contact plugs comprise tungsten (W), and
the barrier metal layer comprises titanium nitride (TiN).

5. The semiconductor device of any preceding claim, wherein the connection portions of the conductive patterns pass through the upper insulating layer, and extend in a direction parallel to an upper surface of the second substrate.

6. The semiconductor device of any preceding claim, wherein:
the upper surface of each of the first contact plugs is on a first level,
lower surfaces of the connection portions are on a second level, and the second level is lower than the first level, and
upper surfaces of the connection portions are on a third level, and the third level is higher than the first level.

7. The semiconductor device of claim 6, wherein a difference in height between the second level and the third level is in a range of 30 nm to 500 nm.

8. The semiconductor device of any preceding claim, wherein each of the connection portions comprises a line pattern.

9. The semiconductor device of claim 8, wherein:
the line pattern has a first width perpendicular to a longitudinal direction,
the first width is equal to or greater than a diameter of each of the first contact plugs, and
the first width is equal to or less than 1.2 times the diameter of each of the first contact plugs.

10. The semiconductor device of claim 8 or 9, wherein:
the line pattern has a first width perpendicular to a longitudinal direction,
the first width is equal to or greater than a diameter of each of the second contact plugs, and
the first width is equal to or less than 1.2 times the diameter of each of the second contact plugs.

11. The semiconductor device of any preceding claim, wherein upper surfaces of the connection portions of the conductive patterns are on a same level as lower surfaces of the bit lines.

12. The semiconductor device of any preceding claim, wherein upper surfaces of the connection portions of the conductive patterns are on a same level as an upper surface of the upper insulating layer.

13. An electronic system comprising:
a semiconductor storage device according to any preceding claim, the semiconductor storage device further including an input/output pad electrically connected to the lower interconnection lines; and
a controller electrically connected to the semiconductor storage device through the input/output pad, the controller configured to control the semiconductor storage device.

14. The electronic system of claim 13, wherein an upper surface of the connection portion is coplanar with an upper surface of the capping insulating layer.
